# EUROPEAN PATENT APPLICATION

(11) **EP 0 727 924 A2**
(43) Date of publication of application: **21.08.1996**
(21) Application number: 96301037.6
(22) Date of filing: 15.02.1996
(51) Int. Cl.: H05K 1/02

(54) **Method of sequentially mounting a number of components and apparatus therefor**

(30) Priority: 15.02.1995 JP 26524/95
(71) Applicant: KABUSHIKI KAISHA TOSHIBA, Kawasaki-shi, Kanagawa-ken 210 (JP); Japan Tobacco Inc., Minato-Ku Tokyo 105 (JP)
(72) Inventor: Hirose, Tatsuya, Yokkaichi-shi, Mie-ken (JP)
(74) Representative: Waldren, Robin Michael

(57) **Abstract**

A method of sequentially mounting a number of components on mounting points on a printed circuit board includes a processing for dividing a mounting area (A) on the circuit board (16) into a plurality of blocks (B). In the processing, the mounting area (A) is divided into a plurality of sub-areas (C). The adjacent sub-areas (C) are merged together depending upon the number of mounting points (P) contained in each sub-area (C) so that the mounting area (A) is divided into the blocks (B) each of which contains twenty-five mounting points (P). Subsequently, a sequence of the blocks (B) is determined so that the sum of distances between the adjacent blocks (B) is rendered as small as possible. Finally, a mounting sequence of the components (15) on the mounting points (P) in each block (B) is determined. In the determination of the mounting sequence in each block (B), the length of a route obtained by connecting the mounting points (P) in series to one another serves as a performance function with respect to a permutation of the mounting points (P). The permutation rendering the performance function as small as possible is obtained by a probabilistic optimization method. The distance between the mounting points (P) is parameterized.

## Description

This invention relates to an apparatus for automatically mounting components such as electronic components on an object such as printed circuit boards, and more particularly to such a mounting apparatus wherein each of mounting heads holding the component is relatively moved between the apparatus and each of mounting points on the circuit board so that a number of components are mounted on the mounting points on the circuit board in a predetermined sequence.

A component mounting apparatus has been developed for automatically mounting components such as electronic components on objects such as printed circuit boards. The component mounting apparatus comprises a plurality of mounting heads each obtaining and carrying electronic components. Each mounting head is moved relative to a number of mounting points on a circuit board so that the predetermined components are sequentially mounted on the mounting points. A sequence of the mounting of the components on the number of mounting points is desirably determined so that a mounting period of time or a mounting route or a distance of the relative movement of the mounting head is rendered shortest. This sequence will be referred to as "mounting sequence."

The determination of the mounting sequence for provision of the shortest distance of movement of the mounting head may be treated as optimization of combination. In the optimization of combination, a performance function f is defined with respect to each of members or elements e₁, e₂, e₃, ..., and eₙ of a set S. An optimum element eₒₚₜ is obtained from the set S so that the value of the performance function f is rendered optimum under a predetermined condition given to the set S.

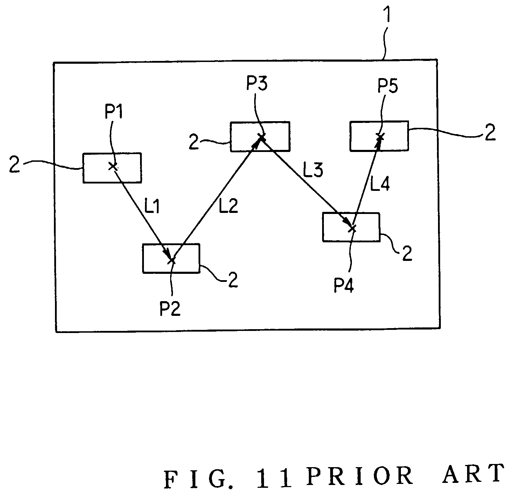

FIG. 11 illustrates one of prior art methods of determining the mounting sequence of the components. Five components 2 are to be sequentially mounted on five mounting points P₁ to P₅ on a circuit board 1 respectively. With respect to one element of a set which is one permutation where the components are mounted in the sequence of P₁, P₂, P₃, P₄, and P₅, a performance function f for obtainment of the total distance of movement required of the mounting head for the mounting of the components is defined as L₁+L₂+L₃+L₄ where L₁ is a distance between the mounting points P₁ and P₂, L₂ is a distance between the mounting points P₂ and P₃, L₃ is a distance between the mounting points P₃ and P₄, and L₄ is a distance between the mounting points P₄ and P₅.

The performance function f is obtained with respect to each element of the set S in the manner as described above. The optimum element eₒₚₜ which is a sequence providing the shortest distance of movement is obtained so that the value of the performance function f is rendered minimum. However, the set S whose elements are equal to the number of permutations of all the mounting points, that is, a factorial of the number of all the mounting points. Accordingly, even when the components are mounted on only ten mounting points, the number of the mounting sequences reaches ten factorial or 3,628,800. The obtainment of all the performance functions f of these combinations results in an enormously large quantity of calculation. Actually, however, a probabilistic optimization is employed.

The probabilistic optimization is employed to obtain an approximate solution with high probability of approximation to the precise solution when the quantity of calculation becomes enormously large. The calculation can be interrupted when the probability of approximation to the precise solution has been rendered sufficiently high. Consequently, the quantity of calculation can be reduced. With employment of the above-described approximate solution, the mounting sequence of the components can be determined so that the distance of relative movement of each mounting head can be rendered sufficiently short though it is not the shortest strictly.

In recent years, however, the electronic components have been miniaturized or densified. For example, there is a case where about 300 components are mounted on a single circuit board. In such a case, a quantity of calculation is geometrically increased with the increase in the number of mounting points or components even when the approximate solution is employed. Consequently, a calculation period of time is even increased for determination of the mounting sequence of the components which can sufficiently shorten the mounting period. For example, about 30 minutes are required for the calculation when 300 components are to be mounted. A new method has been desired which can shorten the calculation period.

Therefore, an object of the present invention is to provide a method of sequentially mounting a number of components in which a component mounting period can be sufficiently shortened and an apparatus therefor.

Another object of the present invention is to provide a method of sequentially mounting a number of components in which a calculating period required for an optimum mounting order can be shortened and an apparatus therefor.

In one aspect, the present invention provides an apparatus for sequentially mounting a number of components which comprises a mounting head movable relative to an object having thereon a plurality of mounting points and control means for controlling the mounting head so that the same repeatedly carries the component to the mounting point to mount the component thereon, characterized in that the control means comprises first means for controlling the relative movement of the mounting head so that the components are sequentially mounted on the mounting points of each of a plurality of blocks from one block to another, which blocks being obtained by dividing an area of the object having the plurality of mounting points thereon, and second means for controlling the mounting head so that the components are mounted on the mounting points in a predetermined sequence of the blocks which is determined so that the sum of distances of the relative movement of the mounting head between each block and one of the blocks adjacent thereto is rendered minimum.

According to the present invention, the mounting of the components is carried out in each of the blocks. Accordingly, calculation is executed for determination of a suitable mounting sequence of the components in each block. Since the division of the area of the object into the blocks reduces the number of members or elements of a set in the mounting sequence, the calculation period of time required for determination of the mounting sequence providing the shortening of the mounting period of time can be reduced. Furthermore, the sequence of the blocks is determined so that the sum of distances of the relative movement of the mounting head between each block and one of the blocks adjacent thereto is rendered minimum. Accordingly, the distance of relative movement of the mounting head is rendered shortest when the mounting head is moved from one block to a subsequent one after completion of the mounting of the components in said one block. Consequently, the entire period of time required for the mounting of the components can be reduced.

In a preferred embodiment, the blocks include one or more blocks each of which is formed by dividing the area of the object containing the mounting points into sub-areas and thereafter merging one or more adjacent sub-areas with one sub-area depending upon the number of mounting points contained in each sub-area.

In another preferred embodiment, the number of mounting points contained in each block is previously determined in view of a calculation period of time required for determination of a mounting sequence of the components on the mounting points in each block.

A large quantity of calculation is required for determination of the suitable mounting sequence of the components on the mounting points in each block when the number of mounting points contained in each block is excessively large. On the other hand, the calculation period of time is increased when the number of blocks is increased in the case where the number of mounting points contained in each block is excessively small. The calculation time period for determination of the suitable mounting sequence can be reduced together with the suitable number of blocks which is neither large nor small when the number of mounting points contained in each block is previously determined in view of the calculation time period for determination of the mounting sequence in each block, as is described above.

In further another preferred embodiment, the mounting sequence of the components on the mounting points in each block is obtained in turn by parameterizing a distance between each mounting point and a mounting point adjacent thereto, by employing the sum of the parameters as a performance function, and by determining the mounting sequence by a probabilistic optimization method so that the value of the performance function is rendered as small as possible. Since the distance between the mounting points is parameterized, the numeric values to be processed can be simplified. This, together with use of the probabilistic optimization, provides efficient calculation for determination of the mounting sequence which can sufficiently shorten the mounting period of time.

In another aspect, the present invention provides a method of sequentially mounting a number of components wherein a mounting head is provided to be moved relative to an object having thereon a plurality of mounting points, the mounting head repeatedly carrying the component to the mounting point to mount the component thereon, characterized by the step of controlling the relative movement of the mounting head so that the components are sequentially mounted on the mounting points of each of a plurality of blocks from one block to another, which blocks being obtained by dividing an area of the object having the plurality of mounting points thereon, wherein the mounting head is controlled so that the components are mounted on the mounting points in a predetermined sequence of the blocks which is determined so that the sum of distances of the relative movement of the mounting head between each block and one of the blocks adjacent thereto is rendered minimum.

In the above-described method, the blocks preferably include one or more blocks each of which is formed by dividing the area of the object containing the mounting points into sub-areas and thereafter merging one or more adjacent sub-areas with one sub-area depending upon the number of mounting points contained in each sub-area. Furthermore, it is preferred that the number of mounting points contained in each block is previously determined in view of a calculation period of time required for determination of a mounting sequence of the components on the mounting points in each block. Additionally, the mounting sequence of the components on the mounting points in each block is preferably obtained in turn by parameterizing a distance between each mounting point and a mounting point adjacent thereto, by employing the sum of the parameters as a performance function, and by determining the mounting sequence by a probabilistic optimization method so that the value of the performance function is rendered as small as possible.

The invention will be described, merely by way of example, with reference to the accompanying drawings, in which:
FIG. 1 is a flowchart explaining the procedure for determining a mounting sequence of components in one embodiment in accordance with the present invention;
FIG. 2 is a flowchart explaining in detail the processing in step S1 in the flowchart of FIG. 1;
FIGS. 3A to 3F are views explaining a manner of dividing a mounting area into blocks;
FIG. 4 is a graph showing the relationship between the number of mounting points and a calculation period of time required per mounting point in the obtainment of the mounting sequence;
FIG. 5 is a view showing the distance between the blocks on the mounting area;
FIGS. 6A to 6D are views explaining a manner of determining an initial block and a final block in the mounting sequence;
FIGS. 7A to 7C are views showing an example of determination of the initial and the final blocks in the mounting sequence;
FIG. 8 is a view explaining parameterization of distances among the mounting points;
FIGS. 9A and 9B are views showing an example of determination of the mounting sequence on the basis of the parameters;
FIG. 10 is a plan view of a component mounting apparatus carrying out the method of the embodiment in accordance with the present invention; and
FIG. 11 is a view explaining a prior art manner of determining the mounting sequence.

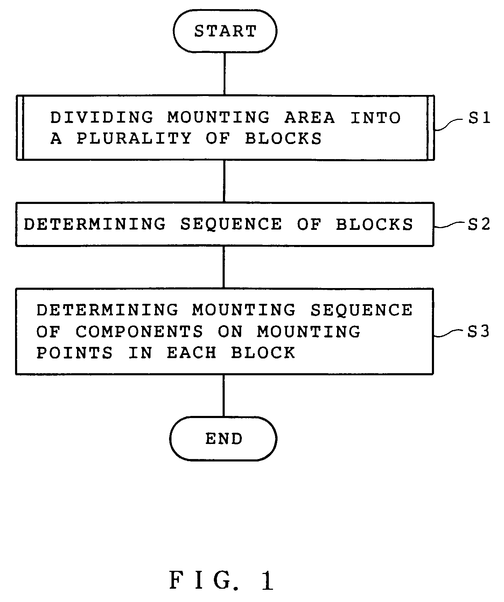

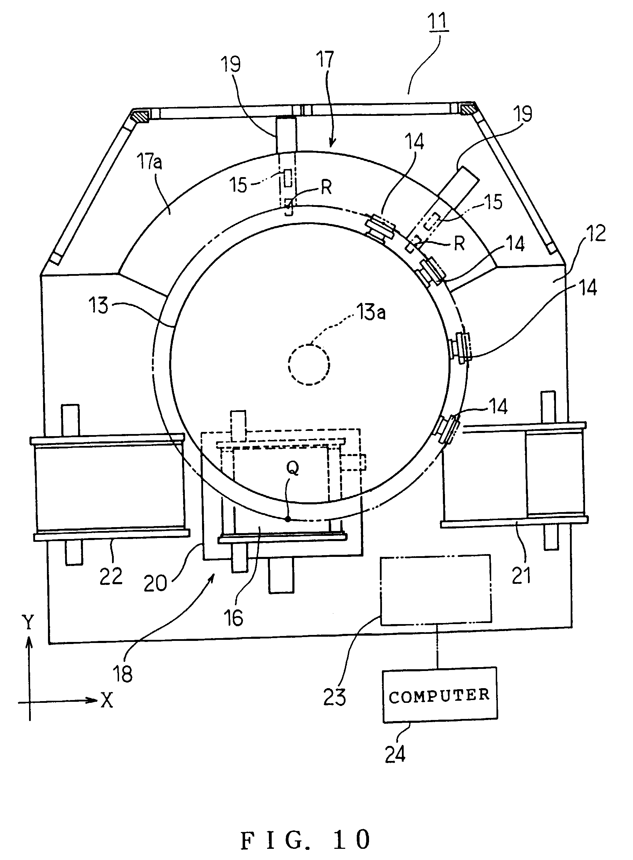

One embodiment of the present invention will be described with reference to FIGS. 1 to 10. The invention is applied to a component mounting apparatus of the continuous rotation cycloid curve movement type. First, the construction of the apparatus will be described. Referring to FIG. 10, the component mounting apparatus is shown. Since the apparatus is described in detail in U.S. Patent No. 5,307,558 transferred to the applicants of the present application, its construction will be briefly described hereinafter. The apparatus comprises a main body 11 having a base 12. A rotating drum 13 is provided in a central portion of the base 12 for rotation in the horizontal direction about a shaft 13a. The rotating drum 13 is adapted to be continuously rotated clockwise via a reduction gear mechanism by a drive motor (neither of them shown) provided on the base 12.

A plurality of mounting heads 14 (twelve in the embodiment) are mounted on the outer circumference of the rotating drum 13 so as to be arranged circumferentially at equal intervals. Some of the mounting heads 14 are shown in FIG. 10. Each mounting head 14 includes a suction nozzle mounted on the lower end thereof for sucking and then carrying an electronic component 15 to mount the same onto a circuit board 16 such as a printed circuit board serving as an object on which the components are to be mounted. Each mounting head 14 is adapted to be turned counterclockwise about a shaft extending radially of the rotating drum 13 with the suction nozzle being directed downward. Accordingly, with rotation of the rotating drum 13 and turn of the mounting head 14, each suction nozzle carries out a cycloid curve movement having on the circumference of the rotating drum 13 a plurality of bottom dead points at each of which the rotational speed of the rotating drum 13 and the turning speed of the mounting head 14 are denied by each other such that the ground speeds of the suction nozzle in the horizontal and vertical directions with respect to the base 12 become zero. Each suction nozzle is connected to a pressure control mechanism (not shown) for switching between the positive and negative pressure conditions.

A feed station 17 is provided at the rear side of the base 12 to be disposed along the outer circumference of the rotating drum 13. The feed station 17 supplies the electronic components 15 to the mounting heads 14. A mounting station 18 is provided in front of the rotating drum 13 on the base 12. The components 15 are mounted onto the circuit board 16 at the mounting station 18.

The feed station 17 includes an arc-shaped feed table 17a and a plurality of component feeders 19 (a part of them shown) such as tape feeders detachably mounted thereon. Each component feeder 19 holds a number of components 15 and feeds them one by one to a component supply point at the forward end thereof. The component supply point of each component feeder 19 is adapted to correspond to one of suction points R or one of a plurality of bottom dead points of the mounting heads 14.

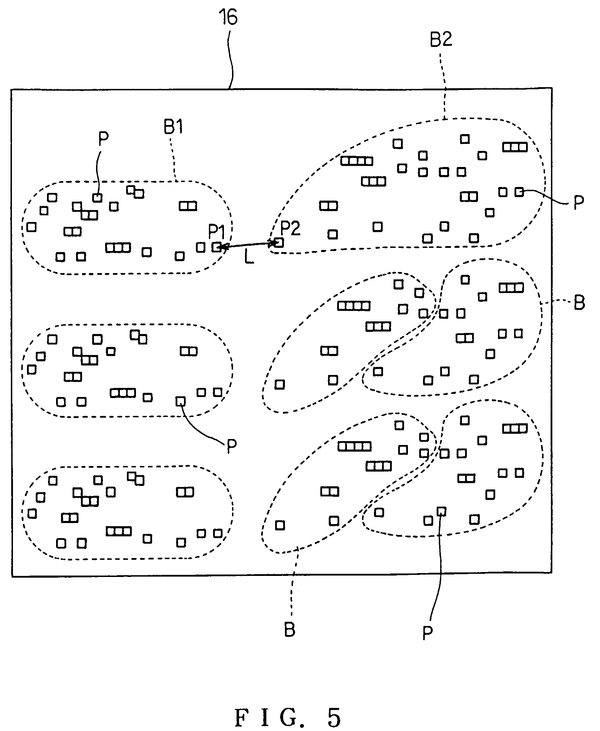

The mounting station 18 includes an X-Y table 20 on which the circuit board 16 is to be placed. The X-Y table 20 is movable horizontally, that is, in the X-axis and Y-axis directions. The mounting station 18 further includes a feed-in conveyor 21 disposed on the right of the X-Y table 20 for conveying the circuit board 16 thereto and a take-out conveyor 22 disposed on the left of the X-Y table 20 for conveying the circuit board 16 therefrom. The X-Y table 20 moves the circuit board 16 on the basis of the X-Y coordinate system peculiar to the apparatus so that each of predetermined mounting points P (see FIG. 5) on the circuit board 16 corresponds to a mounting point Q of the mounting head 14 or the bottom dead point located in the front of the apparatus.

A control device 23 comprising a microcomputer is provided at the front portion of the base 12 for controlling the above-described mechanisms. In a control manner of the control device 23, each mounting head 14 obtains the predetermined components 15 at the feed station 17 and then carries the components 15 to the predetermined mounting points P on the circuit board 16 to mount them on the mounting points P in accordance with a mounting program containing data of a mounting sequence of the components which will be described later. The apparatus is arranged to automatically repeat the above-described mounting work.

A computer 24 of the work station class is connected via a high-speed network such as LAN to the control device 23 in the embodiment. Data of position coordinates of all the mounting points P on the circuit board 16 and types of the components to be mounted is input to the computer 24. Based on the data, the computer 24 determines the mounting sequence of the components to compose the mounting program. In the determination of the mounting sequence of the components, the computer 24 divides an area of the circuit board 16 containing a plurality of mounting points P dispersed thereon into a plurality of blocks according to an installed software. A sequence of the blocks with respect to the mounting of the components is determined so that the distance or period of movement of the X-Y table 20 or the circuit board 16 placed thereon is rendered as short as possible. Then, a mounting sequence of the components in each block is determined so that the distance or period of movement of the circuit board 16 is rendered as short as possible, whereupon the mounting sequence of the components to be mounted onto all the mounting points P is determined.

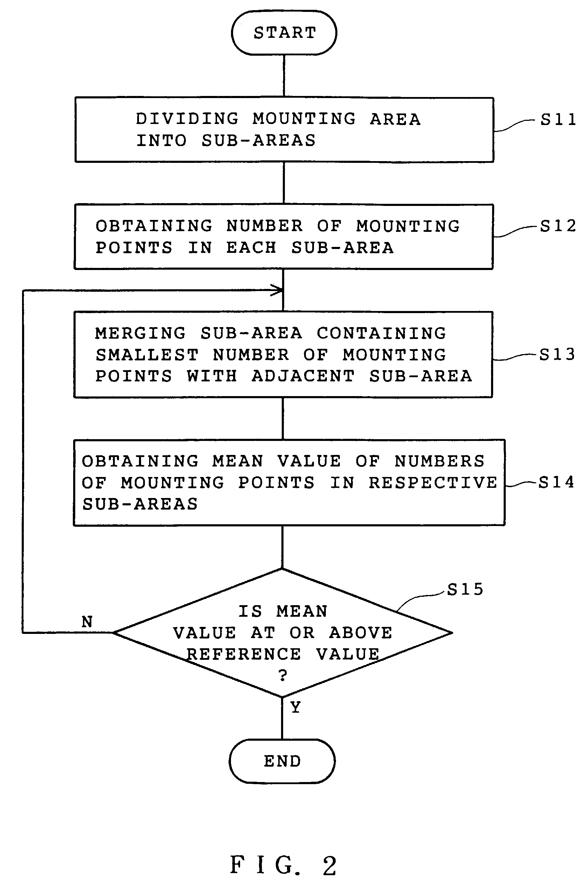

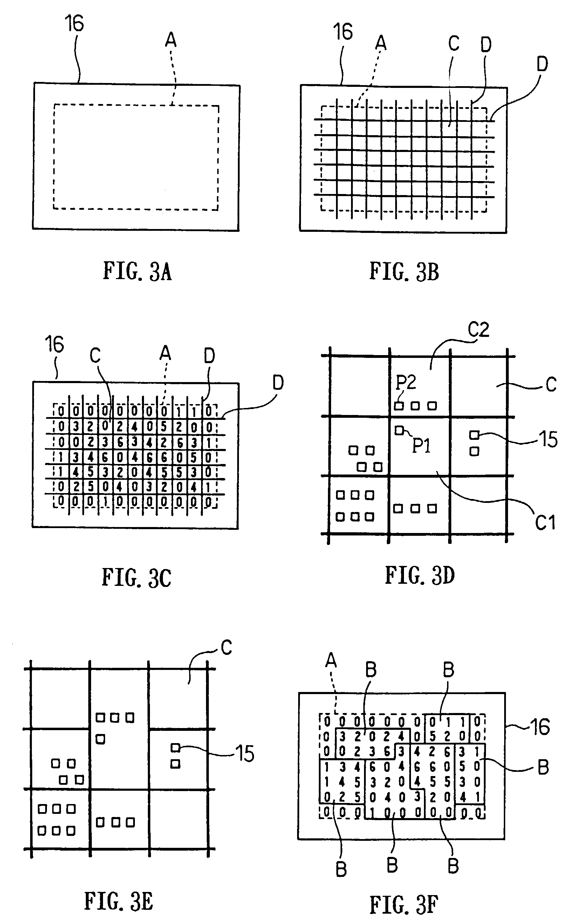

The above-described manner of determining the mounting sequence of the components by means of the computer 24 will be described in detail with reference to FIGS. 1 to 9. Referring to the flowchart of FIG. 1 showing the procedure of determination, a mounting area A (see FIG. 3A) of the circuit board 16 containing a plurality of mounting points P is divided into a plurality of blocks B (see FIG. 3F) at step S1. FIG. 2 shows the processing at step S1 in more detail. In FIG. 2, the mounting area A is divided into sub-areas C. In the embodiment, at step S11, the mounting area A is partitioned by evenly spaced horizontal and vertical imaginary lines D arranged in the form of a lattice so that a number of sub-areas C are defined as shown in FIG. 3B. The number of mounting points P contained in each sub-area C is counted at step S12. FIG. 3C shows the results of the count executed at step S12. The numeral in each mesh designates the number of the mounting points P contained in the corresponding sub-area C.

One or more adjacent sub-areas C are merged with one sub-area C depending upon the number of mounting points P contained therein such that the blocks B are formed, at step S13. In the embodiment, the merger is carried out in such an algorithm that one or more sub-areas C containing the least number of mounting points P (except for zero) are merged with one sub-area C adjacent thereto so that a new block B is formed. In the example of FIG. 3D, the sub-area C₁ contains only one mounting point P₁, and the upper sub-area C₂ contains the mounting point P that is nearest to the mounting point P₁ in the sub-area C₁. Consequently, the sub-area C₁ is merged with the sub-area C₂ such that a new block as shown in FIG. 3E is formed. The new area contains four mounting points P.

The mean value of the numbers of mounting points P in the respective divided areas or blocks is obtained at step S14. The computer 24 determines at step S15 whether the obtained mean value is at or above a reference value (25 in the embodiment). Determining in the negative at step S15, the computer 24 returns to step S3 to repeat the merger of areas. The computer completes the processing for division of the mounting area into the blocks B when the mean value of the numbers of mounting points P in the blocks is at or above the reference value. FIG. 3F shows the condition where the division has been completed.

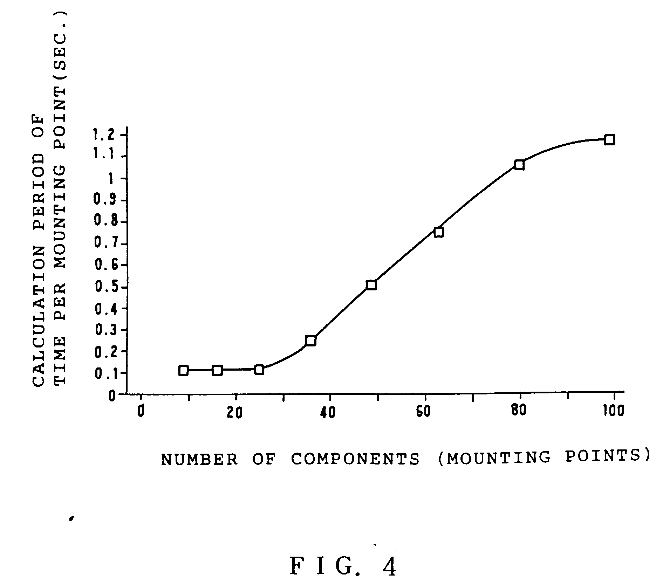

The above-mentioned reference value is determined in the following manner in the embodiment. FIG. 4 shows the relation between the number of components 15 or mounting points P and a period required for calculation per mounting point P in the calculation wherein the method of probabilistic optimization is employed for obtaining a mounting sequence of the components which renders the performance function minimum. As obvious from FIG. 4, the calculation period per mounting point P does not almost change until the number of mounting points P reaches 25 but rapidly increases when the number of mounting points P exceeds 25. For example, when the number of mounting points P is 100, the calculation period per mounting point P requires 1.15 seconds according to FIG. 4. The calculation period in total becomes 115 seconds (=1.15×100). On the other hand, when the mounting area is divided into four blocks B each of which contains 25 mounting points P, the calculation period per mounting point P requires 0.1 seconds and the total calculation period becomes 10 seconds (=0.1×25×4). Furthermore, the determination of the sequence of the blocks takes a long period, as will be described later, when the mounting area is divided into an excessively large number of blocks B. Consequently, the calculation may be carried out most efficiently when each block B contains 25 mounting points P.

The computer 24 returns to the procedure shown in FIG. 1 upon completion of the processing for division of the mounting area into the blocks B. At step S2, the sequence of the blocks is determined. This sequence is obtained by the use of the probabilistic optimization. In the obtainment of the sequence, the performance function is defined so that the sum of distances between each block B and the subsequent one in the permutation of blocks B is rendered as small as possible. Referring to FIG. 5, distance L between one block B₁ and another block B₂ adjacent thereto is obtained as the shortest distance between one of the mounting points P₁ contained in the block B₁ and one of the mounting points P₂ contained in the block B₂.

The sum of distances between the adjacent blocks B obtained as described above serves as a performance function. A permutation rendering the performance function as small as possible is obtained by the probabilistic optimization, whereupon the sequence of the blocks is determined. Consequently, the circuit board 16 or the X-Y table 20 can be moved as short distance as possible required in a period from the completion of the mounting work for one block B to the start of the mounting work for the subsequent block B or the distance of relative movement of the mounting head 14 can be rendered as short as possible.

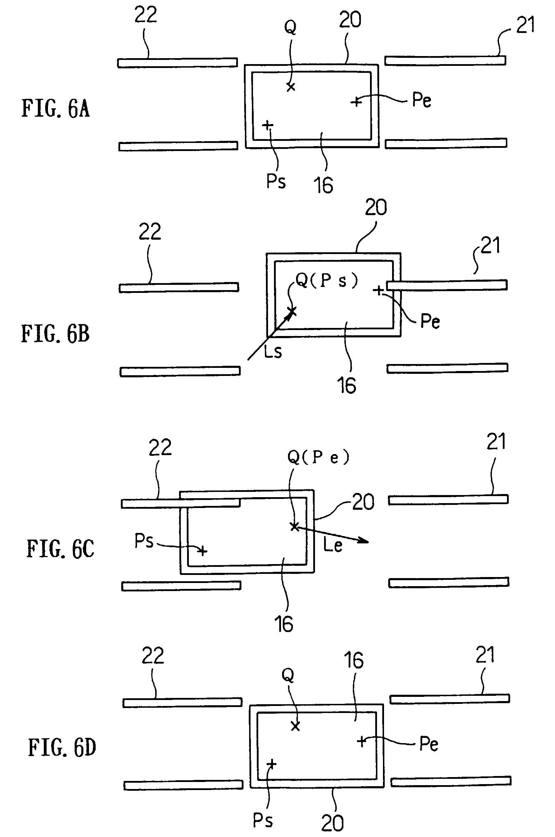

In the determination of the sequence of the blocks, the initial and the final blocks in the sequence may be determined as follows. The circuit board 16 is adapted to be carried on the feed-in conveyor 21 to be set on the X-Y table 20 occupying a reference position fixed relative to the base 12, as is shown in FIG. 6A. Furthermore, the circuit board 16 is adapted to be carried by the take-out conveyor 22 from the X-Y table 20 also occupying the reference position. The mounting point Q of the mounting head 14 is fixed relative to the X-Y table 20 occupying the reference position. The point Q occupies a slightly upper left-hand position in FIGS. 6A to 6D. Accordingly, in order that the component 15 is mounted on the initial mounting point P_{S} on the circuit board 16 set on the X-Y table 20, the X-Y table 20 needs to be moved a distance L_{S} until the point P_{S} coincides with the mounting point Q, as is shown in FIG. 6A. Furthermore, the X-Y table 20 needs to be returned a distance Lₑ to the reference position after the component 15 has been mounted on the final mounting point Pₑ, as is shown in FIGS. 6C and 6D. Accordingly, the initial and the final mounting points P_{S} and Pₑ, that is, the initial and the final blocks B in the mounting sequence of the components are previously specified so that the distances L_{S} and Lₑ are rendered as short as possible, whereupon the total distance or period of movement of the X-Y table 20 can be shortened.

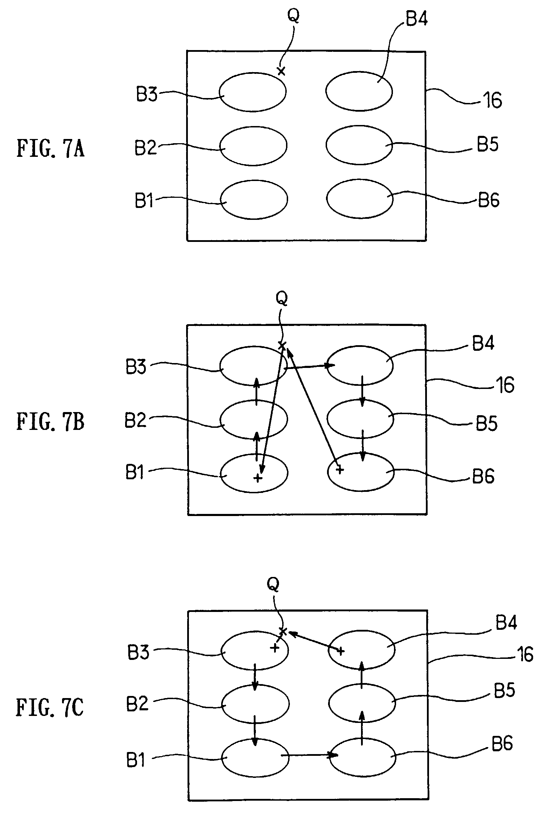

FIG. 7A shows a case where the circuit board 16 contains six blocks B₁ to B₆. When the mounting of the components is determined to be carried out in the sequence of the blocks B₁, B₂, B₃, B₄, B₅, and B₆ as shown in FIG. 7B, the distances between the mounting point Q and the initial and the final blocks B₁ and B₆ are relatively long. On the other hand, when the mounting of the components is determined to be carried out in the sequence of the blocks B₃, B₂, B₁, B₆, B₅, and B₄ as shown in FIG. 7C, the distances between the point Q and the initial and the final blocks B₃ and B₄ are rendered shorter. Thus, the mounting work can be efficiently carried out when the blocks B nearer to the mounting point Q are selected as the initial and the final blocks in the sequence.

Upon determination of the sequence of the blocks B, the mounting sequence of the components in each block B is determined at step S3. In the determination of the mounting sequence in each block, the permutation of the mounting points P is determined so that a route connecting all the mounting points P in the block B provides the shortest distance. In other words, the length of the route obtained by connecting the mounting points P in series to one another serves as the performance function. A permutation of the mounting points P is obtained by the probabilistic optimization so that the value of the performance function is rendered as small as possible. In the embodiment, the distances between the mounting points P are parameterized for the purpose of further simplification in the calculation.

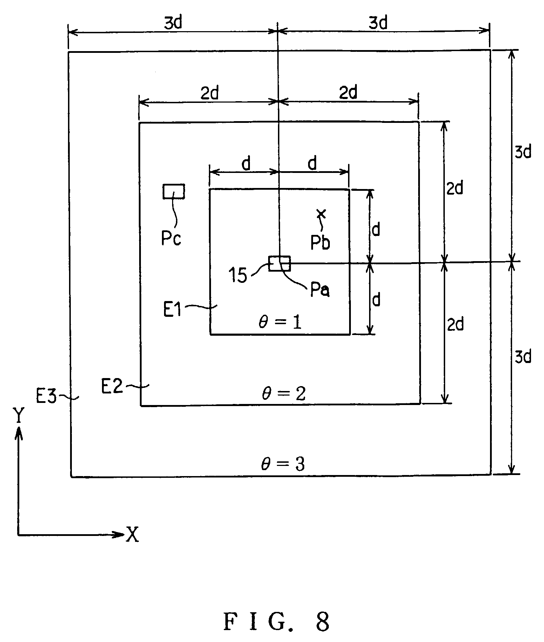

Referring to FIG. 8, a square E₁ is supposed which is defined by straight lines which are apart from one mounting point Pₐ by distance d in the directions of X and Y or in the horizontal and vertical directions. When another mounting point P_{b} is present within the square E₁ or on the lines defining the same, the distance between the mounting points Pₐ and P_{b} is represented as parameter θ, which parameter is set as θ=1. Furthermore, another square E₂ is supposed which is defined by straight lines which are apart from the point Pₐ by distance 2d. When another mounting point P_{c} is present within the square E₂ and outside the square E₁, the distance between the mounting points Pₐ and P_{c} is represented as θ=2. Similarly, the distances θ from the mounting points Pₐ are represented as θ=3, 4, 5, ... The performance function is obtained on the basis of the distances represented by the parameter θ. The permutation of the mounting points P is obtained by the probabilistic optimization so that the performance function is rendered as small as possible, whereby the mounting sequence of the components to be mounted on the mounting points P is obtained.

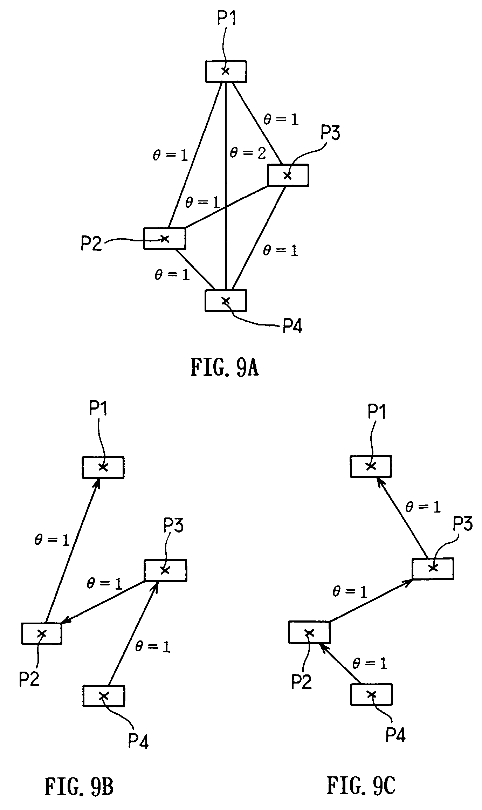

FIG. 9A shows the case where a permutation is obtained with respect to four mounting points P₁ to P₄ so that the performance function is rendered as small as possible. Since the performance functions become 3 in both of the routes according to the mounting sequences shown in FIGS. 9B and 9C, both routes are shortest. Accordingly, each route is an optimum sequence. Thus, since the distance between the mounting points is parameterized, numeric values to be processed are simplified. Consequently, the mounting sequence minimizing the value of the performance function can be readily obtained, and accordingly, the mounting sequence can be determined in a shorter period of time. The above-described determination of the mounting sequence is made regarding all the blocks B, so that the mounting sequence of all the components is determined with respect to the mounting points P on the circuit board 16.

According to the above-described embodiment, the mounting sequence of the components providing a sufficiently short mounting period of time can be determined in a shorter period of time. The prior art method requires about 30 minutes to calculate the mounting sequence when the circuit board contains 300 mounting points. In the method of the above-described embodiment, however, only a little less than one minute is required for calculation when the circuit board contains 600 mounting points.

In the foregoing embodiment, the mounting area of the circuit board is divided into the sub-areas, and thereafter, some sub-areas are merged with one sub-area so that each block is formed. Alternatively, the mounting area of the circuit board may be simply divided into several equal areas, or the mounting area may be divided into several areas from one end of the circuit board in the direction of the opposite end thereof so that each divided area contains a predetermined number of mounting points. Furthermore, the sequence of the blocks may be determined without parameterization of distances. Additionally, both of the initial and the final mounting points onto which the components are to be mounted may be determined beforehand, and then, the mounting sequence for the other mounting points may be determined.

## Claims

1. An apparatus for sequentially mounting a number of components which comprises a mounting head (14) movable relative to an object (16) having thereon a plurality of mounting points (P) and control means (23) for controlling the mounting head (14) so that the same repeatedly carries the component (15) to the mounting point (P) to mount the component (15) thereon, characterized in that the control means (23) comprises first means (24) for controlling the relative movement of the mounting head (14) so that the components (15) are sequentially mounted on the mounting points (P) of each of a plurality of blocks (B) from one block to another, which blocks being obtained by dividing an area of the object (16) having the plurality of mounting points (P) thereon, and second means (24) for controlling the mounting head (14) so that the components (16) are mounted on the mounting points (P) in a predetermined sequence of the blocks (B) which is determined so that the sum of distances of the relative movement of the mounting head (14) between each block (B) and one of the blocks (B) adjacent thereto is rendered minimum.

2. An apparatus according to claim 1, characterized in that the blocks (B) include one or more blocks each of which is formed by dividing the area (A) of the object (16) containing the mounting points (P) into sub-areas (C) and thereafter merging one or more adjacent sub-areas (C) with one sub-area (C) depending upon the number of mounting points (P) contained in each sub-area (C).

3. An apparatus according to claim 1, characterized in that the number of mounting points (P) contained in each block (B) is previously determined in view of a calculation period of time required for determination of a mounting sequence of the components (15) on the mounting points (P) in each block (B).

4. An apparatus according to any one of claims 1 to 3, characterized in that a or the mounting sequence of the components (15) on the mounting points (P) in each block is obtained in turn by parameterizing a distance between each mounting point (P) and a mounting point (P) adjacent thereto, by employing the sum of the parameters as a performance function, and by determining the mounting sequence by a probabilistic optimization method so that the value of the performance function is rendered as small as possible.

5. A method of sequentially mounting a number of components wherein a mounting head (14) is provided to be moved relative to an object (16) having thereon a plurality of mounting points (P), the mounting head (14) repeatedly carrying the component (15) to the mounting point (P) to mount the component (15) thereon, characterized by the step of controlling the relative movement of the mounting head (14) so that the components (15) are sequentially mounted on the mounting points (P) of each of a plurality of blocks (B) from one block to another, which blocks (B) being obtained by dividing an area (A) of the object (16) having the plurality of mounting points (P) thereon, wherein the mounting head (14) is controlled so that the components (15) are mounted on the mounting points (P) in a predetermined sequence of the blocks (B) which is determined so that the sum of distances of the relative movement of the mounting head (14) between each block (B) and one of the blocks (B) adjacent thereto is rendered minimum.

6. A method according to claim 5, characterized in that the blocks (B) include one or more blocks each of which is formed by dividing the area (A) of the object (16) containing the mounting points (P) into sub-areas (C) and thereafter merging one or more adjacent sub-areas (C) with one sub-area (C) depending upon the number of mounting points (P) contained in each sub-area (C).

7. A method according to claim 5, characterized in that the number of mounting points (P) contained in each block (B) is previously determined in view of a calculation period of time required for determination of a mounting sequence of the components (15) on the mounting points (P) in each block (B).

8. A method according to any one of claims 5 to 7, characterized in that a or the mounting sequence of the components (15) on the mounting points (P) in each block is obtained in turn by parameterizing a distance between each mounting point (P) and a mounting point (P) adjacent thereto, by employing the sum of the parameters as a performance function, and by determining the mounting sequence by a probabilistic optimization method so that the value of the performance function is rendered as small as possible.
